# EUROPÄISCHE PATENTSCHRIFT

(11) **EP 0 466 233 B1**
(45) Veröffentlichungstag und Bekanntmachung des Hinweises auf die Patenterteilung: **10.04.1996**
(21) Anmeldenummer: 91201638.3
(22) Anmeldetag: 27.06.1991
(51) Int. Cl.: H03F 3/72

(54) **Schaltungsanordnung zum wahlweisen Verstärken von Signalen**
Circuit for selective amplification of signals
Circuit pour amplification sélective de signaux

(30) Priorität: 04.07.1990 DE 4021290
(43) Veröffentlichungstag der Anmeldung: 15.01.1992
(73) Patentinhaber: Philips Patentverwaltung GmbH, D-22335 Hamburg (DE); Philips Electronics N.V., NL-5621 BA Eindhoven (NL)
(72) Erfinder: Moll, Holger, W-2104 Hamburg 92 (DE)
(74) Vertreter: Peters, Carl Heinrich, Dipl.-Ing.

(56) Entgegenhaltungen:
- FR-A- 1 564 066
- US-A- 4 494 077

## Beschreibung

Die Erfindung bezieht sich auf eine Schaltungsanordnung zum wahlweisen Verstärken eines von wenigstens zwei Signalen.

Derartige Schaltungsanordnungen sind beispielsweise einsetzbar in Videosignal-Verarbeitungsschaltungen, in denen Videosignale aus unterschiedlichen Videosignalquellen zur Weiterleitung an eine Videosignalsenke bearbeitet werden. Im allgemeinen ist jedoch auch eine Anwendung bei der Verarbeitung beliebiger Signale möglich.

Bei einer derartigen Zusammenführung von Signalwegen von verschiedenen Signalquellen her auf eine Signalsenke kann es erwünscht sein, in einem vorgegebenen Betriebszustand Signalwege zu unterbrechen, auf denen von den zugehörigen Signalquellen gerade keine Signale zugeführt werden. Derartige, schaltbar ausgeführte Signalwegunterbrechungen werden dann im gesperrten Zustand mit der Spannungsdifferenz zwischen dem Signal von der Signalquelle aus dem unterbrochenen Signalweg und der Signalspannung aus der wirksamen Signalquelle beaufschlagt. Diese Spannungsunterschiede setzen sich zusammen aus den Amplituden etwaiger, den Signalen zugeordneter Signalspannungen sowie Potentialunterschieden in den Signalwegen und können beträchtliche Werte annehmen. Die schaltbaren Signalwegunterbrechungen müssen dann so ausgebildet sein, daß sie diesen Spannungen standzuhalten vermögen.

Bevorzugt werden Schaltungsanordnungen der beschriebenen Art in integrierten Schaltkreisen auf Halbleiterkörpern zusammengefaßt, die in ihrer Geometrie und ihrem Herstellungsprozeß vorrangig darauf ausgelegt sind, eine möglichst verzögerungs- und leistungsarme Signalverarbeitung zu ermöglichen. Derartige integrierte Schaltkreise sind in ihren einzelnen Schaltelementen vielfach nur mit einer sehr geringen elektrischen Spannung belastbar. Wird eine schaltbare Signalwegunterbrechung in dieser Technik ausgeführt, besteht die Gefahr von Spannungsdurchbrüchen und damit der Zerstörung der integrierten Schaltung.

Aus der FRA-1 564 066 ist ein Verfahren und eine Schaltungsanordnung zum Steuern von Farbsignalverstärkern für Fernsehempfänger bekannt, die eine Matrix zum Decodieren der Leuchtdichte- und der Farbinformation, einen Eingangsschaltkreis, der unter anderem die Umschaltung des Empfängers in die Funktion "Schwarz-Weiß" oder "farbig" per Hand oder automatisch ermöglicht, und eine Dreistrahl-Bildröhre umfaßt. Bei dieser Anordnung wird der Ruhepunkt jedes Farbsignalverstärkers in der Weise angepaßt, daß er möglichst genau mit dem Sperrpunkt der korrespondierenden Elektronenstrahlkanone zusammenfällt. Dabei korrespondiert der genannte Ruhepunkt andererseits mit einem Ausgangsstrom des Verstärkers, der im wesentlichen Null ist. Die einheitliche Steuerung der Helligkeit wird gleichzeitig in den drei Verstärkern durch Veränderung der Einstellung der Stufe des Schwarzpegels des dem Eingang des genannten Verstärkers zugeführten Farbsignals bewirkt.

Aus der US-A 4,494,077 ist ein Verstärker bekannt, dem ein erstes Eingangssignal oder über einen Schalter ein zweites Eingangssignal zuführbar sind.

Die Erfindung hat die Aufgabe, eine Schaltungsanordnung zum wahlweisen Verstärken von Signalen derart auszubilden, daß auch bei der Unterbrechung eines Signalweges im normalen Betrieb keine Schädigung des Schaltungsaufbaues auftreten kann.

Zur Lösung dieser Aufgabe ist erfindungsgemäß eine Schaltungsanordnung gemäß dem Patentanspruch 1 vorgesehen.

Durch die erfindungsgemäßen Maßnahmen wird die Spannungsdifferenz an den Signalwegunterbrechungen zuverlässig unabhängig von den im einzelnen Signalverläufen wirksam auf ein zulässiges Maß beschränkt. Mit der erfindungsgemäßen Schaltungsanordnung können dann auch Signale verarbeitet werden, die Signalspannungen nach sich ziehen, die größer sind als die Sperrspannungen, für die die Signalwegunterbrechungen ausgelegt sind.

Vorzugsweise umfaßt die erfindungsgemäße Schaltungsanordnung eine Schaltvorrichtung, die den zur Signalwegunterbrechung jeweils gegensätzlichen Leitungszustand annimmt und über die die Signalspannung der Signalwegunterbrechung wenigstens einseitig zugeleitet wird. Durch diese Schaltvorrichtung ist gewährleistet, daß einerseits die Signalwegunterbrechung bzw. die Signalwegunterbrechungen im gesperrten Zustand stets die Signalspannung zugeführt bekommt und andererseits eine Rückkopplungsschleife über die Signalwegunterbrechung im leitenden Zustand verhindert wird. Umgekehrt wird vorteilhaft die Signalspannung der Schaltvorrichtung in ihrem gesperrten Zustand wenigstens einseitig über die leitend geschaltete Signalwegunterbrechung zugeführt. In dieser weiteren Fortbildung der Erfindung dienen die Schaltvorrichtung und die Signalwegunterbrechung bzw. die Signalwegunterbrechungen als gegenseitige Schutzvorrichtungen zum Verhindern zu hoher Signalspannungen.

Die Schaltungsanordnung gemäß der Erfindung kann bevorzugt einen Stromverstärker umfassen, dessen Eingang wahlweise wahlweise einer der Signalströme zugeführt wird und dessen Ausgang der verstärkte Signalstrom entnommen wird. Ein derartiger Stromverstärker erhöht die Amplitude des ihm an seinem Eingang zugeführten Signalstromes, wohingegen die diesem Signalstrom zugehörige Signalspannung zumindest weitgehend unverändert bleibt. Damit ist die Differenz zwischen der dem zu verstärkenden Signalstrom zugehörigen Signalspannung einerseits und der dem verstärkten Signalstrom zugehörigen Signalspannung andererseits gering; sie umfaßt insbesondere bei bestimmten Ausführungsformen des Stromverstärkers im wesentlichen nur eine konstante Potentialverschiebung. Da sich eine derartige Potentialverschiebung leicht kompensieren läßt, kann der Signalwegunterbrechung bzw. den Signalwegunterbrechungen und der Schaltvorrichtung einseitig die dem zu verstärkenden Signalstrom zugehörige Signalspannung zugeführt werden und an der jeweils anderen Seite die dem verstärkten Signalstrom zugehörige Signalspannung.

Der Stromverstärker ist bevorzugt als Geradeausverstärker ausgebildet. Gegenüber einem Operationsverstärker weist der Geradeausverstärker eine verringerte Schwingneigung auf, die beim Operationsverstärker in der Regel Kompensationsmaßnahmen mit RC-Gliedern nötig macht. Der Geradeausverstärker ist somit einfacher aufgebaut. Insbesondere läßt sich ein derartiger Aufbau vorteilhaft mit einer oder mehreren Signalwegunterbrechungen verbinden, die einen Transistor umfassen, der bevorzugt als Emitterfolger geschaltet ist. Ein Emitterfolger ist wirkungsvoll als Stromverstärker einsetzbar, dessen Spannungsverstärkung im Idealfall 1 ist. Außerdem lassen sich über die Emitterfolger die Signalwege in einfacher Weise schalten. Ein besonders effektives Bauelement wird dabei erhalten, wenn der Transistor vom npn-Typ ist, da diese Transistoren eine höhere Stromverstärkung aufweisen. Andererseits sind aber gerade diese Transistoren gegenüber hohen Sperrspannungen besonders empfindlich, wogegen die erfindungsgemäße Maßnahme wirksame Abhilfe schafft.

In einer vorteilhaften Fortbildung wird die Signalwegunterbrechung auch bei leitender Schaltvorrichtung in den leitenden Zustand überführt, wenn die Signalspannung einen vorgegebenen Schwellenwert über- bzw. unterschreitet. Durch diese Ausbildung kann die Signalwegunterbrechung zusätzlich mit geringem Aufwand als Amplituden- bzw. Aussteuerungsbegrenzung für das zu verstärkende Signal und die zugehörige Signalspannung eingesetzt werden. Bei einem üblicherweise mit Transistoren ausgeführten Aufbau der erfindungsgemäßen Schaltungsanordnung können so in einfacher Weise Sättigungszustände und dadurch bedingte Verzögerungszeiten bei der Signalübertragung vermieden werden.

Die Schaltungsanordnung gemäß der Erfindung ist vorteilhaft in einer Signalendstufe zur Videosignalverarbeitung verwendbar. Eine derartige Anwendung zeigt auch das nachfolgende Ausführungsbeispiel, von dem in
- Fig. 1: ein prinzipielles Blockschaltbild der erfindungsgemäßen Schaltungsanordnung,
- Fig. 2: ein Übersichtsschaltbild einer Ausführungsform,
- Fig. 3: ein Detailschaltbild einer Ausführungsform der Erfindung und
- Fig. 4: eine von der Schaltungsanordnung gemäß Fig. 2 umfaßte Referenz- und Schaltsignalaufbereitungsstufe
dargestellt ist.

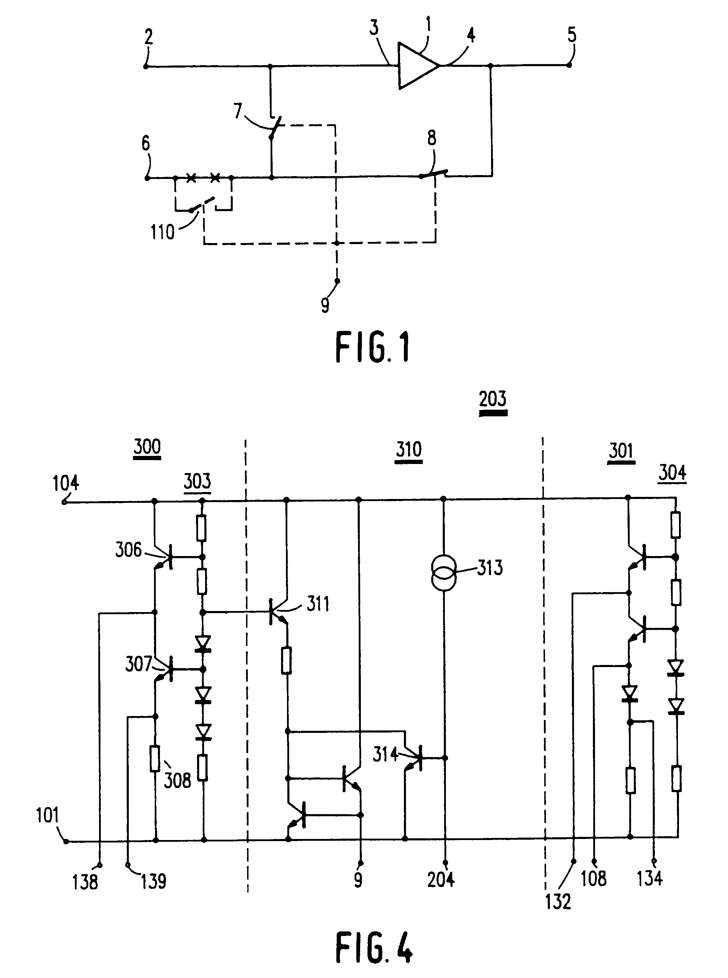

Die Prinzipschaltung nach Fig. 1 umfaßt einen Stromverstärker 1, dem an seinem Eingang 3 von einem ersten Signaleingang 2 ein erster, zu verstärkender Signalstrom zugeführt wird. Am Ausgang 4 wird vom Stromverstärker 1 ein verstärkter Signal strom abgegeben und dem Signalausgang 5 zugeleitet. Der Stromverstärker 1 ist dabei derart ausgeführt, daß die dem Signalstrom zugehörige Signalspannung zumindest im wesentlichen unverändert bleibt.

Wahlweise wird dem Stromverstärker 1 an seinem Eingang 3 von einem zweiten Signaleingang 6 ein zweites, zu verstärkendes Signal über eine Signalwegunterbrechung 7 zugeführt, die in Fig. 1 als Schalter dargestellt ist. In dem in Fig. 1 wiedergegebenen Betriebszustand der Schaltungsanordnung ist die schaltbare Signalwegunterbrechung 7 gesperrt, so daß nur der am ersten Signaleingang 2 fließende Signalstrom verstärkt wird.Dort tritt dann nur die dem zu verstärkenden Signalstrom zugehörige Signalspannung auf, während ohne weitere Maßnahmen das Potential am zweiten Signaleingang 6 davon unabhängig und beispielsweise auf einem konstanten Wert gehalten ist. Über der Signalwegunterbrechung 7 läge dann eine Spannungsdifferenz an, die bei Überschreiten eines durch die Bauart der Signalwegunterbrechung 7 bestimmten Wertes zu einer Beeinträchtigung von deren Funktion oder im schlimmeren Fall zu deren Zerstörung führen könnte.

Daher ist eine Verbindung vom Signalausgang 5 zu dem dem zweiten Signaleingang 6 zugewandten Anschluß der Signalwegunterbrechung 7 vorgesehen, die über eine Schaltvorrichtung 8 unterbrechbar ist. Die Schaltvorrichtung 8 ist in Fig. 1 ebenfalls als Schalter dargestellt und in dem wiedergegebenen Betriebszustand leitend. Über einen mit der Signalwegunterbrechung 7 gemeinsamen Steueranschluß 9 wird die Schaltvorrichtung 8 derart gesteuert, daß sie den zur Signalwegunterbrechung 7 jeweils gegensätzlichen Leitungszustand annimmt. Im wiedergegebenen Betriebszustand wird dann über die Schaltvorrichtung 8 die Signalspannung vom Ausgang 4 des Stromverstärkers 1 der Signalwegunterbrechung 7 einseitig zugeleitet, und zwar an der dem zweiten Signaleingang 6 zugewandten Seite, während an der dem ersten Signaleingang 2 zugewandten Seite der Signalwegunterbrechung 7 die dem zu verstärkenden Signalstrom am ersten Signaleingang 2 zugehörige Signalspannung anliegt. Da diese Spannungen im wesentlichen übereinstimmen, ist die Spannungsdifferenz an der Signalwegunterbrechung 7 sehr gering. Funktionsbeeinträchtigungen oder Zerstörungen der Signalwegunterbrechung 7 sind so wirksam ausgeschlossen.

In dem Fall, daß ein Signal nur vom zweiten Signaleingang 6 zugeführt und der erste Signaleingang 2 unwirksam geschaltet wird, befindet sich die Signalwegunterbrechung 7 - geschaltet über den Steueranschluß 9 - im leitenden und die Schaltvorrichtung 8 im gesperrten Zustand. Dann tritt an der Signalwegunterbrechung 7 keine Spannungsdifferenz mehr auf, die zu einer Funktionsbeeinträchtigung oder Gefährdung derselben führen könnte. Gleichzeitig befindet sich die Schaltvorrichtung 8 im gesperrten Zustand. Ihr wird an einem ihrer Anschlüsse die dem zu verstärkenden Signalstrom zugehörige Signalspannung und an ihrem anderen Anschluß die dem verstärkten Signalstrom zugehörige Signalspannung zugeführt. Da diese im wesentlichen übereinstimmen, ist auch eine Gefährdung der Schaltvorrichtung 8 ausgeschlossen, so daß diese entsprechend der Signalwegunterbrechung 7 aufgebaut sein kann. In diesem Betriebszustand kann sowohl vom ersten Signaleingang 2 als auch vom zweiten Signaleingang 6 ein zu verstärkender Strom zugeführt werden. Im ersten dieser beiden Fälle wird dann der Schaltvorrichtung 8 in ihrem gesperrten Zustand einseitig über die leitend geschaltete Signalwegunterbrechung 7 die Signalspannung des zu verstärkenden Signalstromes zugeführt.

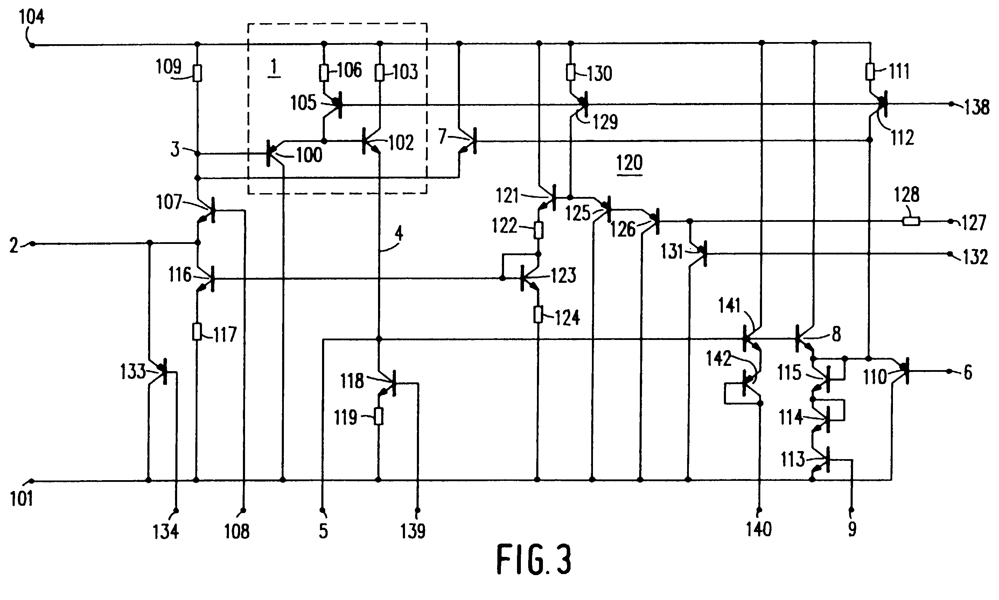

In dem Detailschaltbild gemäß Fig. 3, das für der Fig. 1 entsprechende Elemente identische Bezugszeichen benutzt, ist der Stromverstärker 1 innerhalb einer auf einem Halbleiterkörper integrierten Schaltung als Geradeausverstärker ausgebildet. Er umfaßt einen ersten Verstärkertransistor 100 vom pnp-Typ in Kollektorschaltung, dessen Basisanschluß mit dem Eingang 3, dessen Kollektoranschluß mit einem Masseanschluß 101 und dessen Emitteranschluß mit dem Basisanschluß eines nachfolgenden zweiten Verstärkertransistors 102 verbunden ist. Der zweite Verstärkertransistor 102 ist mit seinem Kollektoranschluß über einen Kollektorwiderstand 103 an einen Versorgungsspannungsanschluß 104 und mit seinem Emitteranschluß an den Ausgang 4 des Stromverstärkers 1 angeschlossen. Über einen Stromquellentransistor 105 mit vorgeschaltetem Emitterwiderstand 106 wird die Verbindung zwischen dem ersten und dem zweiten Verstärkertransistor 100 bzw. 102 vom Versorgungsspannungsanschluß 104 her mit Strom gespeist. Der vom zweiten Verstärkertransistor 102 gelieferte, verstärkte Signalstrom wird über den Ausgang 4 unmittelbar dem Signalausgang 5 zugeführt.

Dem Stromverstärker 1 wird an seinem Eingang 3 wahlweise eines der Signale vom ersten Signaleingang 2 oder vom zweiten Signaleingang 6 zugeleitet. Das erste Signal wird dabei über einen in Basisschaltung betriebenen npn-Transistor 107 geführt, dessen Basisanschluß 108 ein festes Bezugspotential zugeleitet wird. Während der Emitteranschluß des Transistors 107 mit dem ersten Signaleingang 2 verbunden ist, ist der mit dem Eingang 3 verbundene Kollektoranschluß über einen Kollektorwiderstand 109 an den Versorgungsspannungsanschluß 104 geführt. Durch die Stufe aus Transistor 107 und Kollektorwiderstand 109 wird zwischen dem ersten Signaleingang 2 und dem Eingang 3 eine Entkopplung bewirkt.

Das zweite Signal vom zweiten Signaleingang 6 wird über einen pnp-Transistor 110, dessen Emitter-Kollektor-Strecke in Reihe mit einer aus einem Widerstand 111 und einem Stromquellentransistor 112 gebildeten Stromquelle zwischen dem Versorgungsspannungsanschluß 104 und dem Masseanschluß 101 angeschlossen ist, dem Basisanschluß eines die Signalwegunterbrechung 7 bildenden npn-Transistors zugeführt und gelangt von dessen Emitteranschluß an den Eingang 3 des Stromverstärkers 1. Der Kollektoranschluß des die Signalwegunterbrechung 7 bildenden Transistors ist mit dem Versorgungsspannungsanschluß 104 verbunden. Der die Signalwegunterbrechung 7 bildende Transitor ist somit als Emitterfolger geschaltet.

Die Schaltvorrichtung 8 wird in der Schaltungsanordnung nach Fig. 3 durch einen npn-Transistor gebildet, der mit seinem Basisanschluß mit dem Signalausgang 5 und mit seinem Emitteranschluß mit dem Emitteranschluß des pnp-Transistors 110 und über diesen mit dem zweiten Signaleingang 6 verbunden ist. Der Kollektoranschluß ist an den Versorgungsspannungsanschluß 104 geführt.

Der die Schaltvorrichtung 8 bildende Transistor wird durch eine Schaltspannung am Steueranschluß 9 wechselweise in den leitenden oder in den gesperrten Zustand geschaltet. Dazu wird diese Schaltspannung in Fig. 3 dem Basisanschluß eines npn-Schalttransistors 113 zugeleitet, dessen Emitteranschluß mit dem Masseanschluß 101 und dessen Kollektoranschluß über zwei zur Potentialverschiebung dienende, als Dioden und in Reihe geschaltete npn-Transistoren 114, 115 mit dem Emitteranschluß des die Schaltvorrichtung 8 bildenden Transistors verbunden ist. Nimmt die Schaltspannung am Steueranschluß 9 einen hohen Pegel an, befinden sich der Schalttransistor 113 und die Schaltvorrichtung 8 im leitenden Zustand. Am Emitteranschluß des Transistors 110 und dem damit verbundenen Emitteranschluß des die Schaltvorrichtung 8 bildenden Transistors liegt dann ein Potential, welches vom Signalausgang 5 über den Basisanschluß des die Schaltvorrichtung 8 bildenden Transistors um die Basis-Emitter-Spannung des leitenden Transistors versetzt der dem verstärkten Signalstrom zugehörigen Signalspannung nachgeführt wird. In diesem Betriebszustand wird die Basis-Emitter-Strecke des die Signalwegunterbrechung 7 bildenden npn-Transistors im wesentlichen mit der über der Basis-Emitter-Strecke des die Schaltvorrichtung 8 bildenden Transistors in Sperrichtung vorgespannt. Da bei einer Variation des Signals sowohl die Spannung am Eingang 3 als auch am Ausgang 4 bzw. Signalausgang 5 sich gleichsinnig ändert, bleibt die Spannungsdifferenz am die Signalwegunterbrechung 7 bildenden Transistor stets konstant und in einem für diesen Transistor ungefährlichen Bereich. Spannungsdurchbrüche an diesem Transistor oder zu Sättigungseffekten führende Ladungsverschiebungen sind dadurch wirksam ausgeschlossen.

In dem Betriebsfall, in dem ein zweites Signal über den zweiten Signaleingang 6 zugeführt werden soll, wird der Steueranschluß 9 auf niedriges Potential gelegt. Damit sind der Schalttransistor 113 und die Schaltvorrichtung 8 gesperrt, und Strom und Spannung am Emitteranschluß des pnp-Transistors 110 werden durch die als Diode geschalteten Transistoren 114, 115 nicht mehr beeinflußt. Durch den über die Stromquelle 111, 112 in den Transistor 110 fließenden Strom und das zweite Signal am zweiten Signaleingang 6 wird dann die Spannung am Emitteranschluß des die Signalwegunterbrechung 7 bildenden Transistors so gesteuert, daß dieser leitend ist. Der an seinem Emitteranschluß abgegebene Strom steuert über den Eingang 3 den Stromverstärker 1 in gleicher Weise, wie dies auch vom ersten Signalstrom aus dem ersten Signalstromeingang 2 im anderen Betriebszustand der Fall ist. Am Ausgang 4 und damit am Signalausgang 5 wird vom Stromverstärker 1 somit ein verstärkter Signalstrom abgegeben, dessen zugehörige Signalspannung wiederum weitgehend mit derjenigen des zu verstärkenden Signals bis auf eine geringe, beherrschbare, konstante Potentialdifferenz übereinstimmt. Zwischen dem Basisanschluß und dem Emitteranschluß des die Schaltvorrichtung 8 bildenden, jetzt gesperrten Transistors liegt somit im wesentlichen die Basis-Emitter-Spannung des sich im leitenden Zustand befindenden, die Signalwegunterbrechung 7 bildenden Transistors, und zwar in Sperrichtung des Basis-Emitter-Übergangs des die Schaltvorrichtung 8 bildenden Transistors. Auch in diesem Betriebsfall wird somit ein nachteiliger Betriebszustand der Schaltvorrichtung 8 oder auch eine Zerstörung derselben wirkungsvoll vermieden. Beispielsweise beträgt bei einem bestimmten, für die Herstellung der beschriebenen Schaltung vorteilhaften Prozeß die dabei erreichbare, maximal zulässige Sperrspannung an den Basis-Emitter-Übergängen der auf dem Halbleiterkörper erzeugten npn-Transistoren etwa 2,2 V, wohingegen die Spannung zwischen dem Basisanschluß und dem Emitteranschluß des die Signalwegunterbrechung 7 bildenden Transistors im leitenden Zustand etwa 0,7 V beträgt.

Der pnp-Transistor 110 wird bevorzugt über den zweiten Signaleingang 6 mit einem derart gewählten Potential ausgesteuert, daß er bei leitendem Schalttransistor 113 in den gesperrten Zustand übergeht und somit eine Beeinflussung des Stromverstärkers 1 und damit des Signalstroms am Signalausgang 5 wirksam unterbunden ist. Zur Andeutung dieser Funktion im Prinzipschaltbild nach Fig. 1 ist dort zwischen dem zweiten Signaleingang 6 und der Verbindung zwischen der Signalwegunterbrechung 7 und der Schaltvorrichtung 8 ein gestrichelter Schalter skizziert, der bei Unterbrechung der mit Vollinie ausgezogenen Leitungsverbindung vom zweiten Signaleingang 6 her - durch gestrichelte Kreuze angedeutet - die Funktion des Transistors 110 nach Fig. 3 innehat. Passend zu dem in Fig. 1 dargestellten Betriebsfall ist der als Schalter dargestellte Transistor 110 im gesperrten Zustand wiedergegeben. Der Betriebszustand wird ebenfalls über den Steueranschluß 9 gesteuert.

Bei dem vorliegenden Ausführungsbeispiel wird die erfindungsgemäße Maßnahme lediglich zum Schutz von npn-Transistoren angewandt. Da pnp-Transistoren in der Regel und insbesondere bei dem hier beispielhaft angenommenen Herstellungsprozeß mit wesentlich höheren Sperrspannungen belastet werden können, ohne daß dadurch ein Schaden eintritt - bei einem beispielhaft angenommenen Herstellungsprozeß liegt die Spannung für den Basis-Emitter-Durchbruch höher als 18 V - sind derartige Maßnahmen für pnp-Transistoren nicht erforderlich.

Der Aufbau der Schaltungsanordnung gemäß Fig. 3 zeigt ohne zusätzlichen Schaltungsaufwand noch ein weiteres, vorteilhaftes Funktionsmerkmal derart, daß die Signalwegunterbrechung 7 auch bei leitender Schaltvorrichtung 8 in den leitenden Zustand überführt wird, wenn die Signalspannung des über den ersten Signaleingang 2 zugeführten ersten Signals einen vorgegebenen Schwellenwert unterschreitet. In diesem Betriebsfall wird die Spannung am Basisanschluß des die Signalwegunterbrechung 7 bildenden Transistors durch die als Diode geschalteten npn-Transistoren 114, 115, die sich im leitenden Zustand befinden, auf das Zweifache der Basis-Emitter-Flußspannung begrenzt. Sinkt nun die Signalspannung am Eingang 3 (und damit auch die Spannung am Ausgang 4) merklich unter den Wert einer Basis-Emitter-Flußspannung eines der in der Schaltungsanordnung eingesetzten npn-Transistoren, erhöht sich die Spannungsdifferenz an der Basis-Emitter-Strecke des die Signalwegunterbrechung 7 bildenden Transistors derart, daß dieser abweichend von den Vorgaben der Betriebslage in den leitenden Zustand überführt wird. Der nun über die Signalwegunterbrechung 7 einsetzende Strom fließt über den npn-Transistor 107 zwischen dem ersten Signaleingang 2 und dem Eingang 3 und weiter über einen Transistor 116 und dessen Emitterwiderstand 177 nach Masse. Dadurch wird verhindert, daß der Transistor 107 in die Sättigung gerät.

In gleichem Maße wird auch die Spannung am Ausgang 4 und damit am Signalausgang 5 zu niedrigen Werten hin begrenzt, wodurch ein Sättigungszustand einer zwischen dem Ausgang 4 und Masse geschalteten Stromquelle aus einem Transistor 118 mit zugehörigem Emitterwiderstand 119 verhindert wird. Dadurch werden Sättigungseffekte wie z.B. Verzögerungszeiten vermieden, die entstehen, wenn aus dem Zustand der Sättigung heraus die Signalspannung am Eingang 3 und am Ausgang 4 wieder ansteigt und damit der die Signalwegunterbrechung bildende Transistor 7 wieder sperrt.

Die Anordnung nach Fig. 3 umfaßt ferner eine Gleichstromeinstellschaltung 120, durch die ein Speisegleichstrom über den Transistor 116 in die aus dem Kollektorwiderstand 109 und dem Transistor 107 gebildete Reihenschaltung eingespeist wird. Dieser Strom wird durch einen Stromquellentransistor 121 mit nachgeschaltetem Emitterwiderstand 122 vorgegeben, der zwischen dem Versorgungsspannungsanschluß 104 einerseits und über den Eingangszweig eines Stromspiegels an Masse andererseits angeschaltet ist. Der Eingangszweig des Stromspiegels umfaßt einen als Diode geschalteten npn-Transistor 123 mit nachgeschaltetem Emitterwiderstand 124; zum Stromspiegel gehören als Ausgangszweig außerdem der Transistor 116 mit seinem Emitterwiderstand 117.

Der Strom im Stromquellentransistor 121 wird gesteuert über eine Stufe aus zwei pnp-Transistoren 125, 126, die mit ihren Kollektoranschlüssen an Masse geschaltet sind, während dem ersten Transistor 126 dieser Stufe von einem Stromstelleingang 127 über einen Vorwiderstand 128 eine Stellspannung zugeführt wird. Vom Emitteranschluß des ersten Transistors 126 wird der Basisanschluß des zweiten Transistors 125 und von dessen Emitteranschluß der Basisanschluß des Stromquellentransistors 121 gesteuert. Zur Stromkompensation ist der Emitteranschluß des zweiten Transistors 125 außerdem über eine aus einem pnp-Stromquellentransistor 129 mit Emitterwiderstand 130 gebildete Stromquelle an den Versorgungsspannungsanschluß 104 angeschlossen. Vom Basisanschluß des ersten pnp-Transistors 126 führt die Emitter-Kollektor-Strecke eines weiteren pnp-Transistors 131 an den Masseanschluß 101. Der Basisanschluß des Transistors 131 wird mit einer vorgegebenen Referenzspannung über den Anschluß 132 gespeist.

Eine entsprechende Transistoranordnung mit einem pnp-Transistor 133, dessen Basisanschluß über einen Anschluß 134 mit einer festen Referenzspannung versorgt wird, findet sich zur Spannungsbegrenzung auch zwischen dem ersten Signaleingang 2 und dem Masseanschluß 101.

Bei der Schaltungsanordnung nach Fig. 3 werden außerdem den Stromquellen 105, 106 in Verbindung mit 111, 112 und 129, 130 einerseits sowie 118, 119 andererseits über je einen zugehörigen Referenzspannungsanschluß 138 bzw. 139 Referenzspannungen zum Einstellen der Ströme dieser Stromquellen zugeleitet.

Die Anordnung nach Fig. 3 weist zusätzlich zum Signalausgang 5 einen vom Ausgang 4 des Stromverstärkers 1 gesteuerten, entkoppelten Zusatzausgang 140 auf, der über einen Transistor 141 angesteuert wird, dessen Basisanschluß mit dem Ausgang 4 und dessen Kollektoranschluß mit dem Versorgungsspannungsanschluß 104 verbunden ist. Über den Emitteranschluß des Transistors 141 und eine Entkopplungsdiode 142, die aus einem zwischen Basis- und Kollektoranschluß kurzgeschlossenen Transistor besteht, ist der Zusatzausgang 140 angeschlossen.

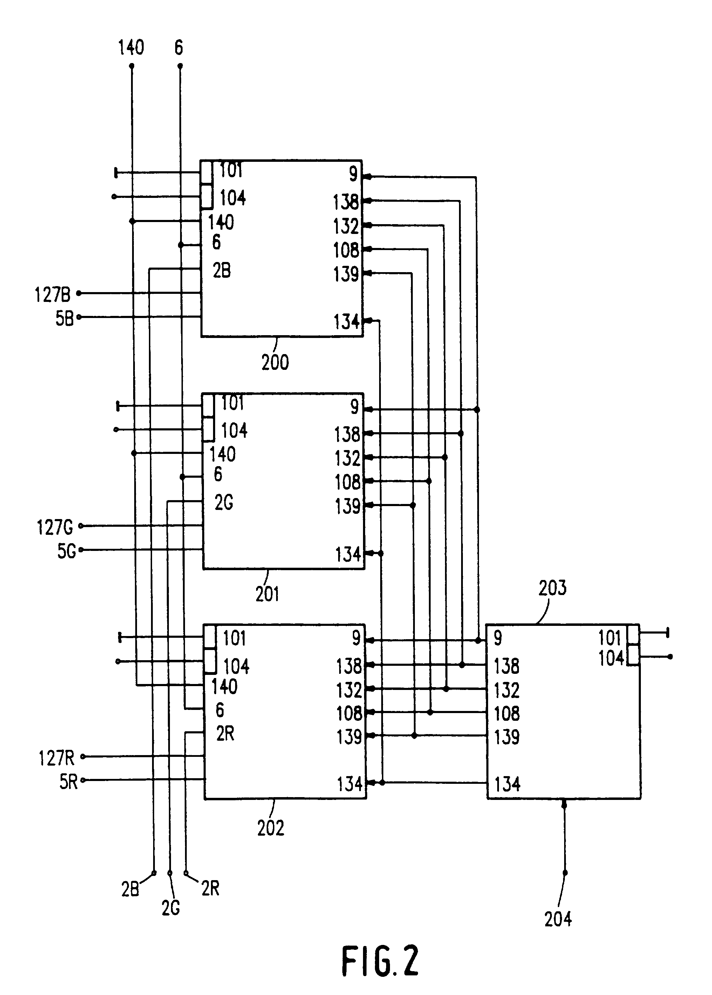

Fig. 2 zeigt die Verwendung einer erfindungsgemäßen Schaltungsanordnung in einer Signalendstufe zur Videosignalverarbeitung. Für jedes der drei Farbsignale ist zur Verstärkung des jeweiligen, zugehörigen Signals ein Stromverstärker mit zugehöriger Beschaltung gemäß Fig. 3 vorgesehen; in der Fig. 2 sind diese Baugruppen gemäß Fig. 3 mit den Bezugszeichen 200 für die Verstärkungsanordnung für das blaue Farbsignal, 201 für das grüne Farbsignal und 202 für das rote Farbsignal bezeichnet. Die Anschlüsse dieser Farbsignalverstärker 200, 201 und 202 tragen die aus den Fig. 1 und 3 bekannten Bezugszeichen; dabei sind allen drei Baugruppen gemeinsame Anschlüsse mit unveränderten Bezugszeichen versehen, während alle Anschlüsse, die für jede Baugruppe gesondert vorgesehen und nicht zwischen den Baugruppen miteinander verbunden sind, mit den aus den Fig. 1 und 3 bekannten Bezugszeichen unter Zusatz des Buchstabens B, G bzw. R (für blau, grün und rot) bezeichnet sind. Bei dieser Zusammenschaltung der drei Farbsignalverstärker 200, 201, 202 sind außer dem Masseanschluß 101 und dem Versorgungsspannungsanschluß 104 auch der Steueranschluß 9 sowie die Referenzspannungsanschlüsse 108, 132, 134 sowie 138, 139 der drei Baugruppen jeweils miteinander verbunden und werden aus einer Spannungserzeugungsstufe 203 gespeist, deren Anschlüsse entsprechend gekennzeichnet sind. In dem Beispiel nach Fig. 2 ist außerdem der Sonderfall dargestellt, daß nur die ersten Signaleingänge 2B, 2G und 2R als getrennte Eingänge für die drei zu verstärkenden Farbsignale ausgebildet sind. Dagegen sind die zweiten Signaleingänge 6 der Farbsignalverstärker 200, 201, 202 an einen gemeinsamen Anschluß geführt. Über diesen Anschluß 6 wird beim vorliegenden Ausführungsbeispiel eine vorgegebene Gleichspannung zugeführt, die in den Farbsignalverstärkern 200, 201, 202 wenigstens nahezu unverändert den Signalausgängen 5B, 5G bzw. 5R zugeleitet werden. Diese Gleichspannung wird insbesondere als sogenanntes Weißsignal zur Erwärmung der durch die in Fig. 2 dargestellte Videosignalendstufe angesteuerten Bildröhre eingesetzt. Dazu wird dem zweiten Signalstromeingang 6 bevorzugt eine zugehörige Signalspannung mit einem Wert zwischen 3 und 7 V zugeführt.

Dagegen sind die Stromstelleingänge 127B, 127G und 127R der drei Farbsignalverstärker 200, 201, 202 voneinander getrennt, so daß für jede Farbkomponente des Videosignals eine gesonderte Einstellung möglich ist. Der Stromstelleingang 127 wird im vorliegenden Fall bevorzugt zur Einstellung des Schwarzwertes im wiederzugebenden Videosignal herangezogen. Insbesondere kann über die Stromstelleingänge ein dreifacher Regelkreis aufgebaut werden, der die Regelung der Schwarzströme in der Bildröhre über die Videoendstufe vornimmt.

Die Spannungserzeugungsstufe 203 weist weiterhin einen Schalteingang 204 auf, dem eine Schaltspannung zugeführt wird, aus der in der Spannungserzeugungsstufe 203 eine Spannung für den Steueranschluß 9 abgeleitet wird.

Fig. 4 zeigt ein detailliertes Schaltbild eines Ausführungsbeispiels für eine Spannungserzeugungsstufe 203 zur Verwendung in einer Schaltungsanordnung gemäß Fig. 2. Die Spannungserzeugungsstufe 203 unterteilt sich in zwei Referenzteilerstufen 300, 301, die jede für sich unabhängig zum Ableiten einzelner Referenzspannungen aus je einem zwischen dem Versorgungsspannungsanschluß 104 und dem Masseanschluß 101 angeordneten Spannungsteiler eingerichtet ist. Der erste Spannungsteiler 303 der Referenzteilerstufe 300 besteht aus einer Reihenschaltung dreier ohmscher Widerstände und dreier Dioden, wobei - beginnend am Versorgungsspannungsanschluß 104 - die ersten beiden Elemente Widerstände sind, gefolgt von den drei Dioden. Nach den ersten drei Elementen des ersten Spannungsteilers 303 sind jeweils Anzapfungen vorgesehen, die mit Basisanschlüssen von Transistoren verbunden sind. Die an der ersten und der dritten Anzapfung angeschlossenen Transistoren bilden mit ihren Kollektor-Emitter-Strecken und einem an den Masseanschluß 101 angeschlossenen Emitterwiderstand eine Reihenschaltung zwischen Masse und dem Versorgungsspannungsanschluß 104. An den Verbindungspunkten zwischen diesen Transistoren 306, 307 und ihrem zugehörigen Emitterwiderstand 308 werden die über die Referenzspannungsanschlüsse 138 und 139 abgeführten Referenzspannungen vom ersten Spannungsteiler 303 gesteuert niederohmig abgegriffen.

Entsprechend ist die Referenzteilerstufe 301 aufgebaut, wobei lediglich die erste Diode im ersten Spannungsteiler 303 entfernt wurde und dafür eine Diode zwischen dem zweiten Transistor (entsprechend 307) und dem Emitterwiderstand (entsprechend 308) eingefügt wurde. Die Elemente des Zweiges der Kollektor-Emitter-Strecken der Transistoren bilden nun drei Abgriffe, die mit den Anschlüssen 108, 132 und 134 für das konstante Bezugspotential am Basisanschluß des Transistors 107 in Fig. 3 sowie die Referenzspannungen an den Transistoren 133 und 131 verbunden sind.

Die Spannungserzeugungsstufe 203 umfaßt weiterhin eine Steuersignalstufe 310, der über den Schalteingang 204 ein Schaltsignal zugeführt werden kann, das in invertierter Form über den Steueranschluß 9, der ebenfalls mit der Steuersignalstufe 310 verbunden ist, den Baugruppen 200, 201, 202 zum Umschalten zwischen den beiden Signaleingängen 2 bzw. 6 zugeleitet wird. Die Steuersignalstufe 310 umfaßt einen Stromquellentransistor 311, dessen Basisanschluß aus einer Anzapfung des ersten Spannungsteilers 303 der Referenzteilerstufe 300 zwischen den - vom Versorgungsspannungsanschluß 104 aus gesehen - ersten beiden Widerständen und den nachfolgenden Dioden gespeist wird. Der Emitteranschluß des Stromquellentransistors 311 ist über einen Emitterwiderstand einerseits mit einer Ausgangsstufe für den Steueranschluß 9 und andererseits mit dem Kollektoranschluß eines Schalttransistors 314 verbunden, dessen Emitteranschluß an den Masseanschluß 101 geführt ist und dessen Basisanschluß mit dem Schalteingang 204 verbunden ist. Zur Speisung des Basisanschlusses des Schalttransistors 314 ist eine Stromquelle 313 zum Versorgungsspannungsanschluß 104 geführt. Die Stromquelle 313 kann analog zum Stromquellentransistor 311 aufgebaut und in gleicher Weise von der Referenzteilerstufe 300 gesteuert sein.

## Patentansprüche

1. Schaltungsanordnung wahlweisen Verstärken eines von wenigstens zwei Signalen (von 2 bzw. 6), von denen wenigstens eines über eine schaltbare Signalwegunterbrechung (7) zugeführt wird, die gesperrt ist, wenn über sie kein Signal geleitet wird, und der in diesem gesperrten Zustand auf der einen Seite eine aus dem zu verstärkenden Signal abgeleitete Signalspannung und auf der anderen Seite eine aus dem verstärkten Signal abgeleitete Signalspannung zugeführt wird.

2. Schaltungsanordnung nach Anspruch 1,
gekennzeichnet durch eine Schaltvorrichtung (8), die den zur Signalwegunterbrechung (7) jeweils gegensätzlichen Leitungszustand annimmt und über die die Signalspannung der Signalwegunterbrechung (7) wenigstens einseitig zugeleitet wird.

3. Schaltungsanordnung nach Anspruch 2,
dadurch gekennzeichnet, daß die Signalspannung der Schaltvorrichtung (8) in ihrem gesperrten Zustand wenigstens einseitig über die leitend geschaltete Signalwegunterbrechung (7) zugeführt wird.

4. Schaltungsanordnung nach Anspruch 1, 2 oder 3,
gekennzeichnet durch einen Stromverstärker (1), dessen Eingang (3) wahlweise eines der Signale zugeführt wird und dessen Ausgang (4) das verstärkte Signal entnommen wird.

5. Schaltungsanordnung nach Anspruch 4,
dadurch gekennzeichnet, daß der Stromverstärker (1) als Geradeausverstärker ausgebildet ist.

6. Schaltungsanordnung nach einem der vorhergehenden Ansprüche,
dadurch gekennzeichnet, daß wenigstens eine der schaltbaren Signalwegunterbrechungen (7) einen Transistor umfaßt.

7. Schaltungsanordnung nach Anspruch 6,
dadurch gekennzeichnet, daß der Transistor als Emitterfolger geschaltet ist.

8. Schaltungsanordnung nach Anspruch 6 oder 7,
dadurch gekennzeichnet, daß der Transistor vom npn-Typ ist.

9. Schaltungsanordnung nach einem der vorhergehenden Ansprüche,
dadurch gekennzeichnet, daß die Signalwegunterbrechung (7) auch bei leitender Schaltvorrichtung (8) in den leitenden Zustand überführt wird, wenn die Signalspannung einen vorgegebenen Schwellenwert über- bzw. unterschreitet.

10. Schaltungsanordnung nach einem der vorhergehenden Ansprüche,
gekennzeichnet durch eine Verwendung in einer Signalendstufe zur Videosignalverarbeitung.

## Claims

1. A circuit arrangement for optionally amplifying one of at least two signals (from 2 or 6, respectively), at least one of which is supplied via a switchable signal path interruption (7) which is inhibited when no signal is applied thereacross, and to one end of which in this inhibited state a signal voltage derived from the signal to be amplified is applied and to the other end of which a signal voltage derived from the amplified signal is applied.

2. A circuit arrangement as claimed in Claim 1, characterized by a switching arrangement (8) which assumes the conducting state opposite to that of the signal path interruption (7) and via which the signal voltage is applied to at least one end of the signal path interruption (7).

3. A circuit arrangement as claimed in Claim 2, characterized in that the signal voltage is applied at least to one end of the switching arrangement (8) in its inhibited state via the conducting signal path interruption (7).

4. A circuit arrangement as claimed in Claim 1, 2, or 3, characterized by a current amplifier (1) to whose input (3) optionally one of the signals is applied and from whose output (4) the amplified signal is taken.

5. A circuit arrangement as claimed in Claim 4, characterized in that the current amplifier (1) is formed as a straight amplifier.

6. A circuit arrangement as claimed in any one of the preceding Claims, characterized in that at least one of the switchable signal path interruptions (7) includes a transistor.

7. A circuit arrangement as claimed in Claim 6, characterized in that the transistor is arranged as an emitter follower.

8. A circuit arrangement as claimed in Claim 6 or 7, characterized in that the transistor is of the npn type.

9. A circuit arrangement as claimed in any one of the preceding Claims, characterized in that the signal path interruption (7) is switched to the conducting state, also when the switching arrangement (8) is conducting, when the signal voltage exceeds or falls short of a predetermined threshold value.

10. A circuit arrangement as claimed in any one of the preceding Claims, characterized by its use in a signal output stage for video signal processing.

## Revendications

1. Montage de circuit permettant d'amplifier de manière sélective l'un d'au moins deux signaux (de 2 ou de 6), dont au moins l'un est acheminé via une interruption de trajet de signaux commutable (7) qui est bloquée lorsqu'aucun signal n'est acheminé par son intermédiaire, et à laquelle sont acheminés, dans cet état bloqué, d'une part, une tension de signal dérivée du signal à amplifier et, d'autre part, une tension de signal dérivée du signal amplifié.

2. Montage de circuit selon la revendication 1, caractérisé par un dispositif de commutation (8), qui adopte l'état passant respectivement en opposition à l'interruption de trajet de signaux (7) et via lequel la tension de signal est au moins acheminée d'un côté à l'interruption de trajet de signaux (7).

3. Montage de circuit selon la revendication 2, caractérisé en ce que la tension de signal du dispositif de commutation (8) dans son état bloqué est acheminé au moins d'un côté via l'interruption de trajet de signaux (7) commutée en mode passant.

4. Montage de circuit selon la revendication 1, 2 ou 3, caractérisé par un amplificateur de courant (1) à l'entrée (3) duquel est acheminé sélectivement un des signaux et à la sortie (4) duquel le signal amplifié est prélevé.

5. Montage de circuit selon la revendication 4, caractérisé en ce que l'amplificateur de courant (1) se présente sous la forme d'un amplificateur direct.

6. Montage de circuit selon l'une quelconque des revendications précédentes, caractérisé en ce qu'au moins l'une des interruptions de trajets de signaux commutables (7) comprend un transistor.

7. Montage de circuit selon la revendication 6, caractérisé en ce que le transistor est monté en émetteur-suiveur.

8. Montage de circuit selon la revendication 6 ou 7, caractérisé en ce que le transistor est un transistor de type npn.

9. Montage de circuit selon l'une quelconque des revendications précédentes, caractérisé en ce que l'interruption de trajet de signaux (7) passe également à l'état conducteur lorsque le dispositif de commutation (8) est conducteur si la tension de signal est supérieure ou inférieure à une valeur de seuil prédéterminée.

10. Montage de circuit selon l'une quelconque des revendications précédentes, caractérisé par une utilisation dans un étage terminal de signaux pour le traitement de signaux vidéo.
